# EUROPEAN PATENT APPLICATION

(11) **EP 4 027 444 A1**
(43) Date of publication of application: **13.07.2022**
(21) Application number: 21166921.3
(22) Date of filing: 06.04.2021
(51) Int. Cl.: H01M 50/204, H01M 10/052, H01M 10/42, H01M 10/44

(54) **BATTERY PACK, METHOD AND VEHICLE**

(30) Priority: 08.01.2021 CN 202110023723
(71) Applicant: Nio Technology (Anhui) Co., Ltd, Hefei City, Anhui 230601 (CN)
(72) Inventor: WANG, Linfeng, Hefei City, Anhui 230601 (CN); FANG, Jie, Hefei City, Anhui 230601 (CN); TZENG, Shizhe, Hefei City, Anhui 230601 (CN); ZHOU, Zerun, Hefei City, Anhui 230601 (CN); LUO, Wenjuan, Hefei City, Anhui 230601 (CN); HE, Chong, Hefei City, Anhui 230601 (CN); WANG, Xianpeng, Hefei City, Anhui 230601 (CN); HAN, Lin, Hefei City, Anhui 230601 (CN)
(74) Representative: Vossius & Partner Patentanwälte Rechtsanwälte mbB

(57) **Abstract**

The invention provides a battery pack, a method and a vehicle. The battery pack battery has a cell group (100). The cell group (100) comprises a lithium iron phosphate cell (A) and a ternary lithium-ion cell (B), wherein the lithium iron phosphate cell (A) and the ternary lithium-ion cell (B) are arranged in series with each another.

## Description

### Technical Field

The invention relates to the technical field of new energy vehicles, and in particular, to a battery pack, a method and a vehicle. In particular, the invention relates to a design solution of a high-performance battery composed of cells with different chemical systems, and a method for improving a precision of measurement of a state of charge of a lithium iron phosphate battery pack.

### Background Art

In order to increase the energy density of battery packs and to increase the cruising range and power output of electric vehicles, for a quite long period of time, ternary lithium-ion batteries have become the main technical route of the industry and the first choice for most new energy vehicles. However, with the large-scale use of the ternary lithium-ion batteries, many battery safety incidents have occurred on the market. Due to the inherent characteristics of the ternary lithium-ion batteries, the safety risks cannot be fundamentally resolved in a short period of time. Lithium iron phosphate batteries have regained attention and become the focus of research due to their outstanding high safety and low costs.

However, lithium iron phosphate has its inherent characteristics, that is, the SOC-OCV (state of charge - open-circuit voltage) curve is very flat, and the SOC can be corrected more accurately only when fully charged or discharged. In actual use, the SOC calculation precision is poor, in particular at a low temperature, which greatly affects the cruising range.

In the case of using lithium iron phosphate battery packs, due to the inaccurate SOC calculation, the charging time estimation will be inaccurate or full charge is impossible, the cruising range calculation deviation during discharging is large, and users need to charge and discharge regularly to increase the SOC calculation precision, resulting in great complaints from the users.

The identification of the OCV of a ternary lithium-ion cell at different temperatures and different SOC intervals is relatively accurate, and the standstill waiting time can be greatly shortened through calibration.

CN 111490304 A provides a battery equalization enabling method and device, a storage medium and a battery pack. The method comprises: determining whether an equalization instruction is received; if it is determined that the equalization instruction is received, determining whether the cell type of a battery monomer includes a lithium iron phosphate cell; if it is determined that the cell type includes the lithium iron phosphate cell, determining whether the measured change value of a state of charge of the battery monomer is smaller than a specified threshold value; if it is determined that the change value of the state of charge is smaller than the specified threshold value, determining whether the obtained available equalization capacity of the battery monomer is larger than a set calibration capacity; and if it is determined that the available equalization capacity is larger than the calibration capacity, carrying out equalization enabling on the battery monomer. In an embodiment of the document, when the change value of the state of charge of the battery monomer of the lithium iron phosphate cell is smaller than the specified threshold value and the available equalization capacity is larger than the calibration capacity, equalization enabling on the battery monomer is carried out, which increases the activation frequency of the battery equalization enabling, thereby improving the equalization effect of a battery.

### Summary of the Invention

An object of one aspect of the invention is to make a battery pack with high safety and low costs. An object of another aspect of the invention is to realize a high-precision SOC calculation.

Furthermore, the invention is also intended to solve or alleviate other technical problems in the prior art.

The invention solves the above problems by providing a battery pack, a method and a vehicle. Specifically, according to one aspect of the invention, provided is
a battery pack having a cell group, wherein the cell group comprises a lithium iron phosphate cell and a ternary lithium-ion cell, wherein the lithium iron phosphate cell and the ternary lithium-ion cell are arranged in series with each another.

Optionally, according to an embodiment of the invention, the lithium iron phosphate cell and the ternary lithium-ion cell are alternately arranged one by one.

Optionally, according to an embodiment of the invention, two lithium iron phosphate cells and one ternary lithium-ion cell are arranged in series as a group.

Optionally, according to an embodiment of the invention, the cell group has only one ternary lithium-ion cell.

Optionally, according to an embodiment of the invention, the lithium iron phosphate cell and the ternary lithium-ion cell are arranged in a row with each other.

According to another aspect of the invention, the invention provides a method for measuring a state of charge of a battery pack, wherein the battery pack is any one of the battery packs as described above, and the method comprises:
performing ampere-hour integral calculation when the battery pack is being charged and discharged; and/or
correcting the calculation of the state of charge by using an open-circuit voltage of the ternary lithium-ion cell during standing of the battery pack when the state of charge of the battery pack is 5% to 95%; and/or
correcting the calculation of the state of charge by using open-circuit voltages of the lithium iron phosphate cell and the ternary lithium-ion cell during standing of the battery pack when the state of charge of the battery pack is 0% to 5% or 95% to 100%.

Optionally, according to an embodiment of the invention, a resistive shunt is used to perform the ampere-hour integral calculation.

According to yet another aspect of the invention, the invention provides a vehicle having any one of the battery packs as described above.

The provided battery pack, method and vehicle have the benefits as follows: a high-precision SOC is obtained on the basis of high safety, the charging time and cruising range can be accurately calculated, and user complaints are reduced; and a balance between the energy density and the cost of the battery pack can be realized, and it is suitable for different models and choices.

### Brief Description of the Drawings

The foregoing and other features of the invention will be apparent with reference to the accompany drawings, in which
Fig. 1 shows a schematic diagram of open-circuit voltage-state of charge curves of a ternary cell and a lithium iron phosphate cell; and
Figs. 2 to 4 respectively show schematic diagrams of the layout of cells of a cell group of a battery pack according to the invention.

### Detailed Description of Embodiments

It can be readily understood that according to the technical solution of the invention, a person of ordinary skill in the art may propose multiple interchangeable structures and implementations without changing the essential spirit of the invention. Therefore, the following specific embodiments and the accompanying drawings are merely exemplary descriptions of the technical solutions of the invention, and should not be construed as the entirety of the invention or construed as the restriction or limitation on the technical solution of the invention.

Orientation terms, such as up, down, left, right, front, rear, front side, back side, top, and bottom, which are or may be mentioned in this description, are defined with respect to the structures shown in the accompanying drawings, and are relative concepts, and therefore may correspondingly vary depending on different positions and different conditions in use. Therefore, these or other orientation terms should not be construed as restrictive terms as well. In addition, the terms "first", "second" and "third", etc. or similar expressions are for description and distinguishing purposes only and should not be construed as indicating or implying relative importance of respective members.

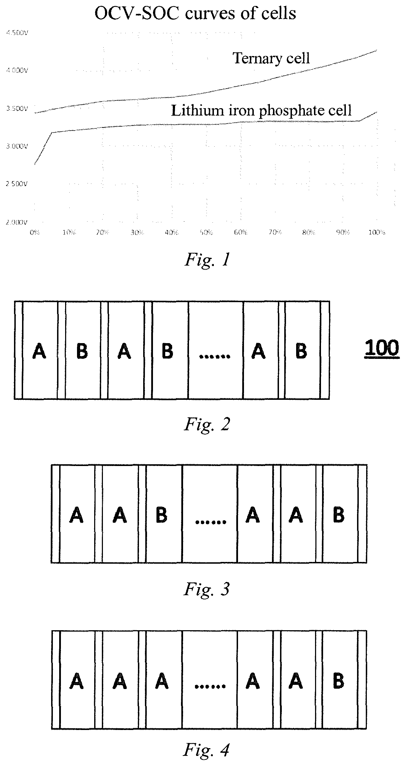

Referring to Fig. 1, a schematic diagram of open-circuit voltage-state of charge curves of a ternary cell and a lithium iron phosphate cell are shown.

It should be understood that the ternary cell is also referred to as a ternary lithium-ion cell, wherein ternary means using nickel salt, cobalt salt and manganese salt as raw materials, for example, the cathode material is made from nickel-cobalt-manganese or nickel-cobalt-aluminium, which has the characteristics of high safety. The lithium iron phosphate cell has high working voltage, high energy density, long cycle life, good safety performance, small self-discharge rate and no memory effect.

Open-circuit voltage (OCV) refers to a voltage in an open-circuit state, that is, when disconnected, and state of charge (SOC) refers to the ratio of the available capacity to the capacity in a fully charged state, when it is 0, it means fully discharged, and when it is 1, it means fully charged.

It can be seen from this figure that the slope of the curve of the ternary cell is larger, facilitating calibration, and the ternary cell has the characteristics of good performance. The curve of the lithium iron phosphate cell is generally flat, and has larger slopes near two ends, and the lithium iron phosphate cell has the characteristics of low costs, good safety and less prone to thermal runaway.

Based on the characteristics of the curves of the two cells and the respective characteristics of their own, this application provides a combination scheme of the ternary cell and the lithium iron phosphate cell.

Referring to Figs. 2 to 4, schematic diagrams of the layout of cells of a cell group 100 of a battery pack according to the invention are respectively shown.

The battery pack has a cell group 100. The cell group 100 comprises a lithium iron phosphate cell A and a ternary lithium-ion cell B, wherein the lithium iron phosphate cell A and the ternary lithium-ion cell B are arranged in series with each another.

It should be understood that the series arrangement does not limit the specific positioning of the lithium iron phosphate cell A and the ternary lithium-ion cell B, but only specifies the connection mode.

It can be seen from the above introduction to the open-circuit voltage-state of charge curves of the lithium iron phosphate cell and the ternary lithium-ion cell and their own characteristics that the cost of the entire cell group and therefore of the entire battery pack is reduced by means of the lithium iron phosphate cell, and due to its characteristics of less prone to thermal runaway, the safety of the battery pack is improved, for example, in case of thermal runaway of the ternary cell, the lithium iron phosphate cell can serve as a barrier to maintain the safety of the entire cell group. Moreover, the use of the ternary cell ensures that the cell group and the battery pack have a good performance. Furthermore, different curve characteristics of the ternary cell and the lithium iron phosphate cell can be used to improve a precision of measurement of the state of charge of the battery pack. In addition, the battery pack may be a traction battery pack.

As an example, with regard to the specific series arrangement of the lithium iron phosphate cell A and the ternary lithium-ion cell B, the lithium iron phosphate cell A and the ternary lithium-ion cell B are alternately arranged one by one (as shown in Fig. 2), for example, in the form of A + B + A + B. Through the alternate appearance of the lithium iron phosphate cell and the ternary cell, it is ensured that thermal runaway of the ternary cell cannot result in thermal runaway of the second adjacent cell (which uses the characteristics of less prone to thermal runaway of the lithium iron phosphate cell), preventing the thermal diffusion of the battery pack, and achieving the maximum energy density and power output. Of course, the form of B + A + B + A is possible, and also falls into the scope of protection of this application.

As another example, two lithium iron phosphate cells A and one ternary lithium-ion cell B are arranged in series as a group, for example, in the form of A + A+ B + A+ A + B(as shown in Fig. 3). The alternate appearance of the two lithium iron phosphate cells and the one ternary cell can reduce the cost, and also has a better performance and contributes to the improvement of the precision of measurement of the state of charge of the battery pack. Of course, the arrangement positions of A and B in a group are not limited, for example, the arrangements of B + A + A, A + B + A, etc. for each group are possible, and each group does not have to be strictly the same, that is, the mixed form of A + A + B + B + A + A + A + B + A, etc. may be used. Furthermore, the grouping form of two ternary lithium-ion cells B and one lithium iron phosphate cell A is also optional.

A person skilled in the art may also use other numbers of lithium iron phosphate cells A and ternary lithium-ion cells B in a group to design the layout of the entire cell group 100 according to actual conditions.

As yet another example, the cell group 100 has only one ternary lithium-ion cell B. The ternary lithium-ion cell B may be positioned at an end portion of the cell group 100 (as shown in Fig. 4) or at other positions in the cell group 100. That is to say, in each module, one ternary cell is used to calculate the SOC of this module in order to reduce the cost to the greatest extent on the premise of obtaining a better performance and facilitating SOC calibration.

The common point of Figs. 2 to 4 is that the lithium iron phosphate cell A and the ternary lithium-ion cell B are arranged in a row with each other. The advantages of the arrangement in a row include facilitating electrical connection (especially in series) of various cells of the cell group 100, and saving the space occupied in a transverse direction.

Furthermore, the lithium iron phosphate cell A and the ternary lithium-ion cell B may be equally spaced apart from each other, and/or have the same size and shape (such as a rectangular shape), thereby standardizing the manufacture and assembly of the entire battery pack.

According to actual conditions (for example, the shape of the space used by a vehicle to accommodate the battery pack), the layout, size, shape, and spacing of the lithium iron phosphate cell A and the ternary lithium-ion cell B can be adapted flexibly. A series design can still be realized by means of wiring.

According to another aspect of the invention, the invention relates to a method for measuring a state of charge of a battery pack, wherein the battery pack is any one of the battery packs as described above, and the method comprises:
performing ampere-hour integral calculation when the battery pack is being charged and discharged; and/or
correcting the calculation of the state of charge by using an open-circuit voltage of the ternary lithium-ion cell B during standing of the battery pack when the state of charge of the battery pack is 5% to 95%; and/or
correcting the calculation of the state of charge by using open-circuit voltages of the lithium iron phosphate cell A and the ternary lithium-ion cell B during standing of the battery pack when the state of charge of the battery pack is 0% to 5% or 95% to 100% (i.e., the start and end of the state of charge).

It should be noted that the above is unrelated to the sequence or steps, but the application scenario is different, that is, the corresponding method is executed according to different application scenarios (working conditions).

It can be seen from the above introduction to the open-circuit voltage-state of charge curves of the lithium iron phosphate cell and the ternary lithium-ion cell and their own characteristics that this method realizes a high-precision SOC calculation of the battery pack by using, in combination, the characteristics of the larger slope of the curve of the ternary lithium-ion cell and the larger slopes of the curve of the lithium iron phosphate cell near ends of the curve. The characteristics of high safety and low costs of the battery pack are also maintained.

As an example, with regard to an ampere-hour integral calculation method, a high-precision resistive shunt is used to perform the ampere-hour integral calculation. In this way, the cost can be reduced.

It should be understood that the battery pack according to the invention can be installed on various vehicles, including battery electric vehicles or hybrid vehicles in the form of cars, trucks, buses, etc. Therefore, the subject matter of the invention further aims to set forth various vehicles provided with the battery pack according to the invention.

In summary, the invention can realize a high-precision SOC calculation of the battery pack on the premise of high safety and low costs based on the combination design of cells with two different chemical systems: ternary and lithium iron phosphate. By using a battery pack with a ternary cell and a lithium iron phosphate cell in a group, on the basis of high safety, a high-precision SOC can be obtained, the charging time and cruising range can be accurately calculated to prevent easy overcharging or failure to fully charge during charging and easy over-discharging or significant reduction in cruising range during discharging, and user complaints are reduced. Through grouping schemes of different forms of a ternary cell and a lithium iron phosphate cell, a balance between the energy density and the cost of the battery pack can be realized, and it is suitable for different models and choices.

It should be understood that all of the above preferred embodiments are exemplary rather than limiting, and any modification or variation made by those skilled in the art to the specific embodiments described above without departing from the concept of the invention shall fall within the scope of legal protection of the invention.

## Claims

1. A battery pack having a cell group (100), **characterized in that** the cell group (100) comprises a lithium iron phosphate cell (A) and a ternary lithium-ion cell (B), wherein the lithium iron phosphate cell (A) and the ternary lithium-ion cell (B) are arranged in series with each another.

2. The battery pack according to claim 1, **characterized in that** the lithium iron phosphate cell (A) and the ternary lithium-ion cell (B) are alternately arranged one by one.

3. The battery pack according to claim 1, **characterized in that** two lithium iron phosphate cells (A) and one ternary lithium-ion cell (B) are arranged in series as a group.

4. The battery pack according to claim 1, **characterized in that** the cell group (100) has only one ternary lithium-ion cell (B).

5. The battery pack according to claim 1, **characterized in that** the lithium iron phosphate cell (A) and the ternary lithium-ion cell (B) are arranged in a row with each other.

6. A method for measuring a state of charge of a battery pack, **characterized in that** the battery pack is a battery pack of any one of claims 1 to 5, and the method comprises:
performing ampere-hour integral calculation when the battery pack is being charged and discharged; and/or
correcting the calculation of the state of charge by using an open-circuit voltage of the ternary lithium-ion cell (B) during standing of the battery pack when the state of charge of the battery pack is 5% to 95%; and/or
correcting the calculation of the state of charge by using open-circuit voltages of the lithium iron phosphate cell (A) and the ternary lithium-ion cell (B) during standing of the battery pack when the state of charge of the battery pack is 0% to 5% or 95% to 100%.

7. The method according to claim 6, **characterized in that** a resistive shunt is used to perform the ampere-hour integral calculation.

8. A vehicle, **characterized by** comprising a battery pack of any one of claims 1 to 5.
